# EUROPEAN PATENT APPLICATION

(11) **EP 0 952 525 A1**
(43) Date of publication of application: **27.10.1999**
(21) Application number: 97949152.9
(22) Date of filing: 18.12.1997
(51) Int. Cl.: G06F 12/16, G06K 19/07

(54) **IC CARD**

(30) Priority: 27.12.1996 JP 35096696
(71) Applicant: ROHM CO., LTD., Kyoto-shi Kyoto 615 (JP)
(72) Inventor: IKEFUJI, Yoshihiro, Rohm Co., Ltd, Kyoto-shi, Kyoto 615 (JP); TAGUCHI, Haruo, Rohm Co., Ltd, Kyoto-shi, Kyoto 615 (JP); CHIMURA, Shigemi, Rohm Co., Ltd, Kyoto-shi, Kyoto 615 (JP)
(74) Representative: Prüfer, Lutz H., Dipl.-Phys.
(86) International application number: JP9704692
(87) International publication number: WO9829815

(57) **Abstract**

An IC card which can normally perform the next data communication processing if there is an abnormality in data communication is provided. When abnormality determination circuit 1 determines that the previous data reception state is normal, before newly received data to be held DA is stored in a data holding memory 2, IC card 100 saves data in a region to write data DA into a data protection memory 3. Meanwhile if abnormality determination circuit 1 determines that the previous data reception state is abnormal, data in data holding memory 2 is recovered using data which has been saved in data protection memory 3 before accessing to data holding memory 2 is started.

## Description

### Technical Field

The present invention relates generally to IC cards, and more particularly, to an IC card whose data can be recovered when an abnormality occurs in a data communication state.

### Background Art

Conventional IC cards for data communication with an externally provided interrogator have been known.

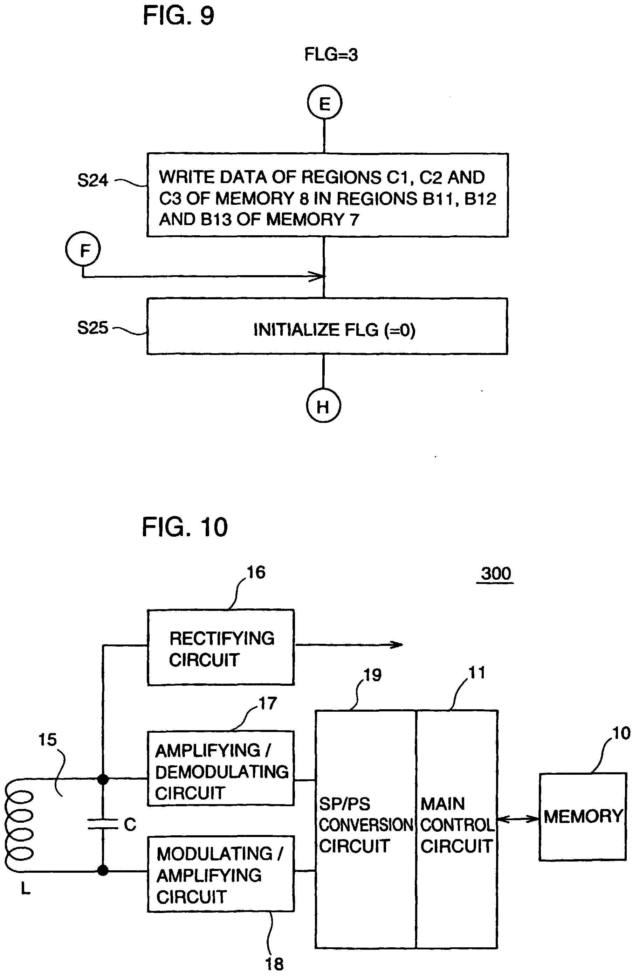

Fig. 10 is a schematic diagram of the basic configuration of a conventional IC card 300. This conventional IC card 300 is a signal superposing, non-contact type IC card which supplies power and transmits/receives information using a signal(s) having one or more frequencies received from an interrogator which is not shown.

Conventional IC card 300 in Fig. 10 is an example of an IC card which uses one frequency, and includes a tuning circuit 15, a rectifying circuit 16, an amplifying/demodulating circuit 17, a modulating/amplifying circuit 18, and an SP/PS conversion circuit 19.

Tuning circuit 15 includes a coil L serving as an antenna and a capacitor C. Rectifying circuit 16 rectifies a signal received at tuning circuit 15 to generate electric power for supply to each part of IC card 300. Meanwhile, amplifying/demodulating circuit 17 amplifies and demodulates information Q from an interrogator received at tuning circuit 15. A signal output from amplifying/demodulating circuit 17 is SP-converted by SP/PS conversion circuit 19.

Referring to Fig. 10, this conventional IC card 300 includes a main control circuit 11 and a memory 10.

Main control circuit 11 processes a signal output from SP/PS conversion circuit 19. Data output from main control circuit 11 which is to be held is stored (held) in memory 10 for holding data.

Main control circuit 11 also reads out data from an addressed region of memory 10 based on the content of information Q received from the interrogator, and generates response information A based on the read out data. Response information A is PS-converted by SP/PS conversion circuit 19, then processed by modulating/amplifying circuit 18 and transmitted to the interrogator through antenna L.

IC card 300 receives a modulated signal (information Q) of a carrier at a frequency f0 from the interrogator in a period T1, and receives an unmodulated wave of a carrier at frequency f0 in a period T2. During period T2, response information A from IC card 300 is transmitted to the interrogator through an electric wave.

In this conventional IC card 300, however, so called "garbage data" could be generated at the time of writing data into memory 10, in other words, data could be strangely altered because of a power supply abnormality (e.g., voltage drop, power supply exhaustion) or the like, and this data abnormality could cause IC card 300 to hold wrong data, which sometimes results in an erroneous operation.

It is an object of the present invention to provide an IC card which permits the content of the memory to be normally recovered and data communication process to be normally performed, even if the previous data reception is not normally performed.

### Disclosure of the Invention

An IC card according to the present invention performs data communication in response to externally applied data and includes a first storage circuit to which the externally applied data is written, a determination circuit to determine how the externally applied data has been written to the first storage circuit, and a second storage circuit into which the data in the first storage circuit is saved, and if the determination circuit determines that the written state of the data is normal, the data already present in a prescribed region is saved in the second storage circuit before externally applied, new data is written into a prescribed region of the first storage circuit, while if the determination circuit determines that the written state of the data is abnormal, the data saved in the second storage circuit is used to recover the data in the prescribed region of the first storage circuit at least once until accessing to the first storage circuit is started after the IC card is newly activated.

Therefore, a main advantage of the present invention lies in that by providing a data holding memory to store data used for data communication, a data protection memory for saving the storage content of the memory, and a determination circuit to determine the written state of the data holding memory, the content of the data holding memory can be recovered and normal data communication can be enabled as a result, even if a writing abnormality occurs.

### Brief Description of the Drawings

Fig. 1 is a diagram of a main part of an IC card 100 according to a first embodiment of the present invention;
Fig. 2 is a flow chart for use in illustration of data holding and data recovering operation in IC card 100 according to the first embodiment;
Fig. 3 is a flow chart for use in illustration of the data holding and data recovering operation in IC card 100 according to the first embodiment;
Fig. 4 is a diagram of a main part of an IC card 200 according to a second embodiment of the present invention:
Figs. 5 to 9 are flow charts for use in illustration of the data holding and data recovering operation in IC card 200 according to the second embodiment; and
Fig. 10 is a diagram of the configuration of a conventional IC card 300.

### Best Modes for Carrying Out the Invention

### First Embodiment

An IC card according to a first embodiment of the present invention includes a data holding memory, a data protection memory into which normal data written in the data holding memory is saved, and a determination circuit to determine the state of data reception. Even if an abnormality occurs in the previous data writing, data in the data protection memory which has been saved can be used to quickly recover the content of the writing region of the data holding memory, so that data communication processing can be continued normally thereafter.

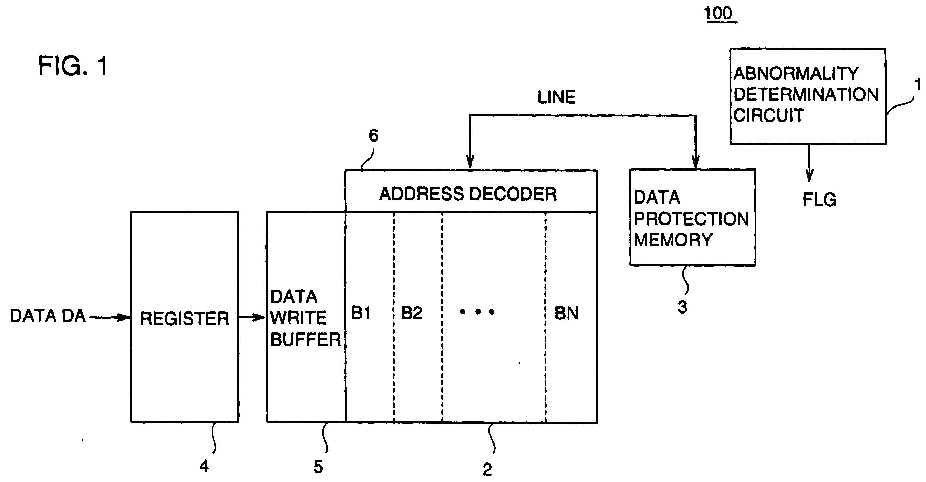

Fig. 1 is a diagram of a main part of IC card 100 according to the first embodiment and shows a part corresponding to memory 10 in the configuration of conventional IC card 300 shown in Fig. 10. Since the remaining part is the same as that of conventional IC card 300, the illustration and description are not provided. Note that an IC card to which the present invention is applied may be either a contact-type or non-contact type IC card.

IC card 100 shown in Fig. 1 is different from conventional IC card 300 in that there are provided a data holding non-volatile memory 2 (hereinafter referred to as data holding memory 2), and a data protection non-volatile memory 3 (hereinafter referred to as data protection memory 3) in place of memory 10 and an abnormality determination circuit 1 to determine the normality/abnormality of the data written state based on the state of the power supply.

Referring to Fig. 1, the configuration of IC card 100 according to the first embodiment will be now described.

A register 4 receives data DA to be held, which is received by the present data communication from a main control circuit 11. Register 4 may be formed by an SRAM. A data write buffer 5 is a circuit to write the data of register 4 into data holding memory 2. An address decoder 6 is a circuit to address a region of interest in data holding memory 2 in a data reading/writing operation from/to data holding memory 2.

Data holding memory 2 receives from register 4 data to be held and stores the received data. In Fig. 1, under the control of main control circuit 11, data DA to be held which is received in one data communication operation is stored in any of regions B1, B2,...,BN. Note that IC card 100 performs data communication processing based on the data stored in data holding memory2.

Data protection memory 3 is a memory to save data stored in data holding memory 2. Data protection memory 3 has a capacity capable of storing data DA received in one data communication operation (equal to or larger than the capacity of each of regions B1, B2, ... ,and BN).

Abnormality determination circuit 1 determines the written state of data based on the sate of power supply. Abnormality determination circuit 1 records the data written state in a state determination flag FLG for output. State determination flag FLG has its value updated based on the processed state of data as will be described. When a power supply abnormality occurs in the process of writing data DA to be held by data holding memory 2, state determination flag FLG holds a value at the point at which the power supply abnormality occurred irrespectively of the succeeding process (abnormal data reception). Meanwhile, state determination flag FLG is initialized when data DA to be held by data holding memory 2 is stored with no power supply abnormality (normal data reception). Note that the value of state determination flag FLG is held until the next data communication processing.

The operation of IC card 100 according to the first embodiment will be now described.

Now, when the previous data reception is normal, in other words, when data holding memory 2 has stored data DA to be held with no power supply abnormality, IC card 100 performs the following processing. Once a new data communication processing is started, before starting writing newly received data DA to be held in data holding memory 2 (data holding processing), IC card 100 performs the processing of saving the content (normal data) of a writing region of memory 2 to store data DA to be held in data protection memory 3 (data protection processing). Then, after the data protection memory is complete, the data holding processing is performed.

When the previous data reception is abnormal, in other words, when a power supply abnormality has occurred in the process of writing data DA to be held in data holding memory 2, IC card 100 performs the following processing. During the period until accessing to data holding memory 2 is started after new activation, IC card 100 performs the process of recovering the content of the writing region of data holding memory 2 using the data which has been saved in data protection memory 3 (data recovering processing). When the data recovering processing is complete, the above-described communication processing is started and data is protected and held.

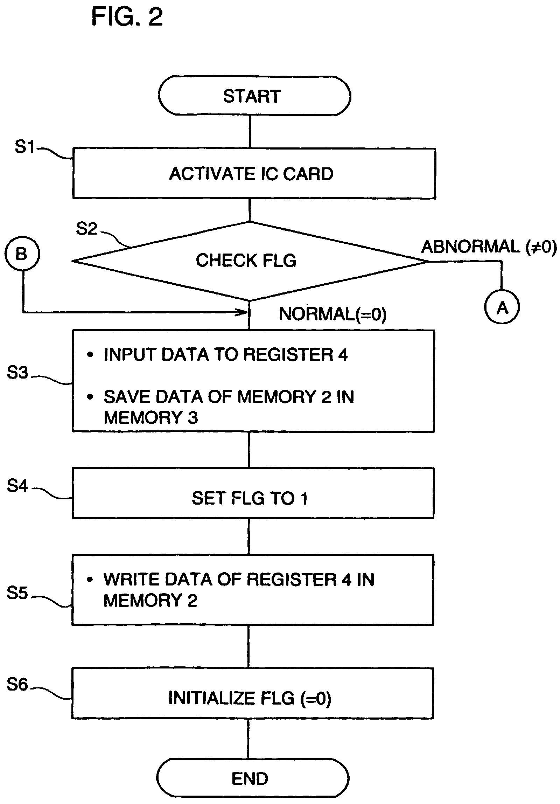

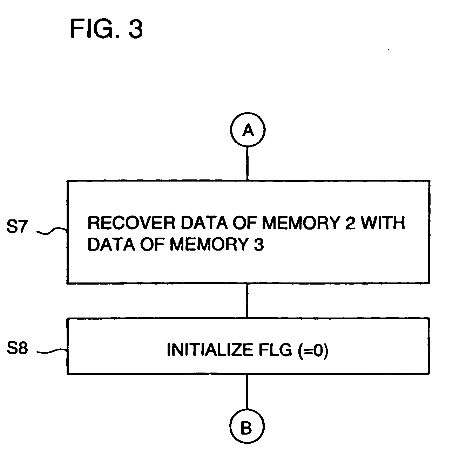

Figs. 2 to 3 are flow charts for use in illustration of the data holding and recovering related operation of IC card 100 according to the first embodiment. Herein, state determination flag FLG takes 0 or 1 and is initialized to 0 when data reception is normally performed.

Referring to Figs. 2 to 3, the data holding and recovering operation of IC card 100 will be now described.

In step S1, IC card 100 is activated.

In step S2, state determination flag FLG is checked. It is checked if the previous data reception has been normal (=0).

First, the case in which state determination flag FLG indicates a normal state (=0) will be described. If state determination flag FLG indicates 0, the data protecting and holding processing in steps S3 to S5 is performed. Though not specifically shown, IC card 100 performs data communication, using data in data holding memory 2 in the process of steps S3 to S5 except for the period in which a writing operation is performed to data holding memory 2.

In step S3, data DA to be held by register 4 is input. Data is read out from the region B1 of data holding memory 2 to write data DA and saved (written) in data protection memory 3 (written). In step S4, state determination flag FLG is set to 1 (corresponding to the state in which data in the region B1 of data holding memory 2 has been saved in data protection memory 3).

In step S5, data DA to be held which is written in register 4 is written in the region B1 of data holding memory 2.

After the processing in step S5 (corresponding to the state in which data DA has been written in data holding memory 2) is complete, state determination flag FLG is initialized in step S6 (=0).

Subsequently, when state determination flag FLG indicates 1, the processing of recovering data in steps S7 to S8 is performed. This processing is performed during the period until accessing to data holding memory 2 is started after IC card 100 is activated.

In step S7, data which has been saved in data protection memory 3 is read out and written into the region B1 of data holding memory 2. As a result, data which could cause an abnormality operation is abandoned, and normal data is written (recovered) in data holding memory 2. After the processing in step S7 (recovery) is complete, state determination flag FLG is initialized (=0) in step S8. After a normal state is attained in step S8, the above-described steps S3 to S6 are performed.

Note that data to be written to data protection memory 3 has only to correspond to the content stored in data holding memory 2 on a one-to-one basis and may be for example the inverse of data in data holding memory 2.

Data protecting memory 2 and data protection memory 3 need only be non-volatile (such as flash memory).

Furthermore, state determination flag FLG may be formed by a non-volatile memory.

As described above, IC card 100 can recover normal data even if an abnormality occurs in data writing because of power supply abnormality, so that the next data communication processing can be normally performed irrespectively of the normality/abnormality of the written state of the previous data.

### Second Embodiment

An IC card according to a second embodiment of the present invention includes a data holding memory 7 which divides data received by one data communication for storage, a data protection memory 8 into which the plurality of pieces of data produced by the dividing can be saved, and an abnormality determination circuit 1.

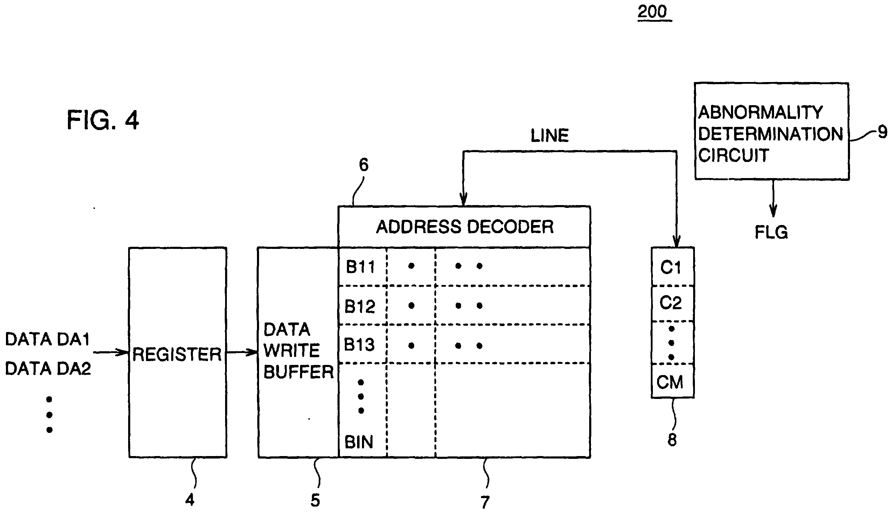

Fig. 4 is a diagram of a main portion of IC card 200 according to the second embodiment and the elements common to those of IC card 100 in Fig. 1 are denoted with the same reference characters and the description is not provided.

According to the second embodiment, data holding memory 7 receives a plurality of pieces of divided data to be held (DA1, DA2,...) by a single data communication. Data holding memory 7 includes regions B11, B12, ..., and these pieces of data to be held DA1, DA2,... are written in respective regions. IC card 200 performs a data communication processing based on data stored in data holding memory 7.

Data protecting memory 8 is a memory to which data stored in a plurality of regions in data holding memory 7 (a plurality of regions among regions B11, B12, ...,B1N,...). In Fig. 4, data protection memory 8 includes regions CM1 to CM, each of which has a capacity equal to or larger than that of each of regions B11, etc. of data holding memory 7.

Abnormality determination circuit 1 records a data processed state in state determination flag FLG for output as described in connection with the first embodiment. State determination flag FLG holds a value when an abnormality occurs and the value is stored until the next data communication processing.

IC card 200 recovers the content of data holding memory 7 using data saved in data protection memory 8 according to the value of state determination flag FLG.

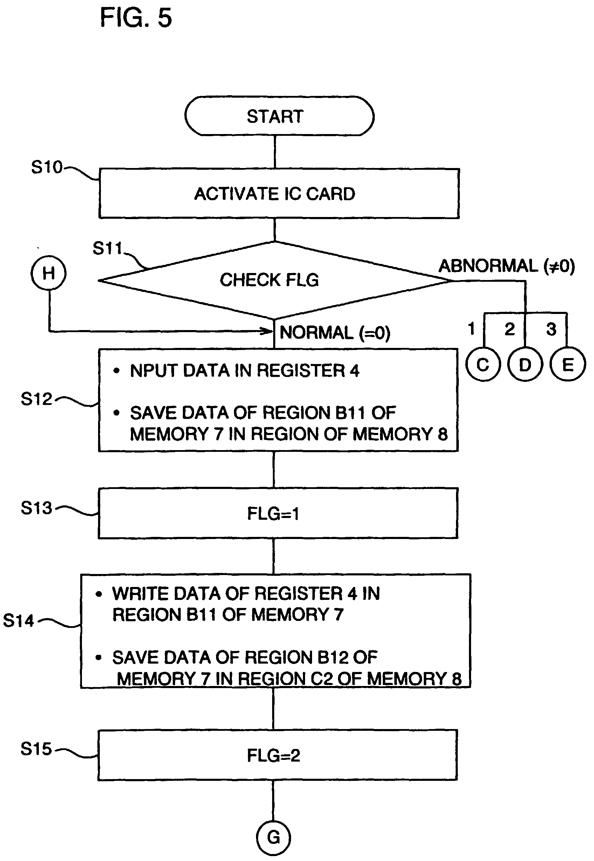

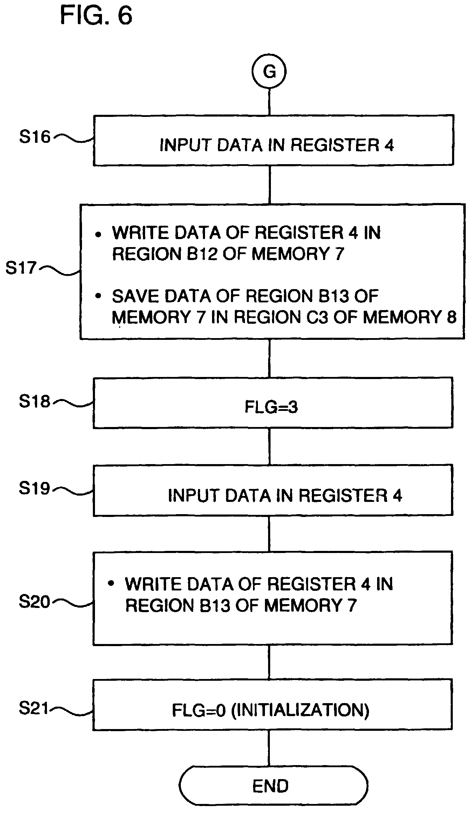

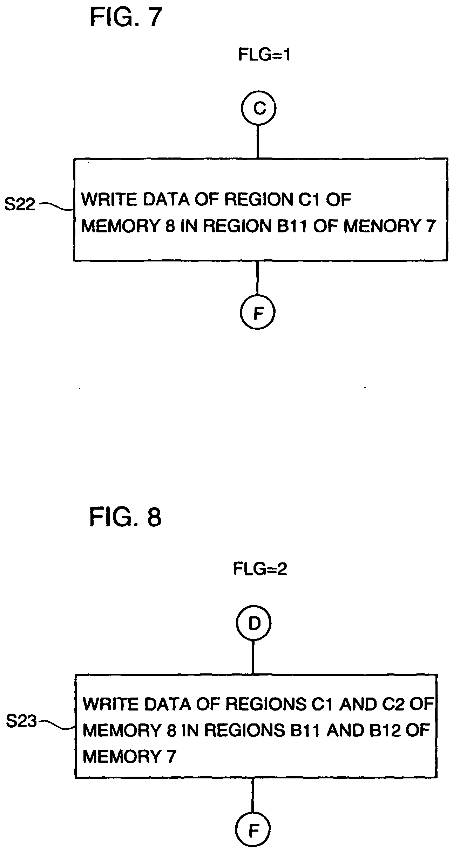

Figs. 5 to 9 are flow charts for use in illustration of the data holding and recovering related operation of IC card 200 according to the second embodiment. Herein, data holding memory 7 receives three pieces of data DA1 to DA3 produced by dividing by a single data communication, and data protection memory 8 includes 3 regions (regions C1 to C3).

Herein, state determination flag FLG takes any of 0, 1, 2 and 3, and is initialized to 0 when data reception is normally performed (when data DA1 to DA3 to be held have been stored in data holding memory 7 without a power supply abnormality).

Referring to Figs. 5 to 9, the data holding and recovering operation of IC card 200 will be now described.

In step S10, IC card 200 is activated.

In step S11, state determination flag FLG is checked. It is then checked if the previous data reception has been normal (=0).

First, the case in which state determination flag FLG indicates a normal state (=0) will be described. If state determination flag FLG indicates 0, the data holding and recovering operation in steps S12 to S20 is performed. Note that though not specifically shown, data in data holding memory 7 can be read out even in the process of steps S12 to S20 except for the period during which a writing operation is performed to data holding memory 7.

In step S12, data DA1 to be held by register 4 is input. Data in the region B11 of data holding memory 7 is read out and saved (written) in the region C1 of data protection memory 8. In step S13, state determination flag FLG is set to 1 (data in the region B11 of data holding memory 7 is saved in the region C1 of data protection memory 8).

In step S14, data DA1 to be held, written in register 4 is written in the region B11 of data holding memory 7 and data in the region B12 of data holding memory 7 is saved in the region C2 of data protection memory 8. In step S15, state determination flag FLG is set to 2 (data in the region B12 of data holding memory 7 is saved in the region C2 of data protection memory 8).

In step S16, data DA2 to be held by register 4 (data to be newly held) is input. In step S17, data DA2 written in register 4 is written in the region B12 of data holding memory 7, and data in the region B13 of data holding memory 7 is saved in the region C3 of data protection memory 8. In step S18, state determination flag FLG is set to 3 (data in the region B13 of data holding memory 7 is saved in the region C3 of data protection memory 8).

In step S19, data DA3 to be held by register 4 (data to be newly held) is input. In step S20, data DA3 written in register is written in the region B13 of data holding memory 7. In step S21, state determination flag FLG is initialized (=0).

Now, the case in which state determination flag FLG indicates any of the numbers other than 0 (=1, 2, 3) will be described. When state determination flag FLG is not 0, a data recovering processing in steps S22, S23 or S24 is performed. This processing is performed before accessing to data holding memory 7 is started after IC card 200 is activated.

When state determination flag FLG is 1 (data in the region B11 of data holding memory 7 has been saved in the region C1 of data protection memory 8), the process transits to step S22. In step S22, data which has been saved in the region C1 of data protection memory 8 is written (recovered) in the region B11 of data holding memory 7.

When state determination flag FLG is 2 (when data in the regions B11 and B12 of data holding memory 7 have been saved in the regions C1 and C2 of data protection memory 8), the process transits to step S23. In step S23, data which have been saved in the regions C1 and C2 of data protection memory 8 are written in regions B11 and B12 of data holding memory 7.

When state determination flag FLG indicates 3 (data in the regions B11, B12 and B13 of data holding memory 7 have been saved in the regions C1, C2 and C3 of data protection memory 8), the process transits to step S24. In step S24, data which have been saved in the regions C1, C2 and C3 of data protection memory 8 are written in the regions B11, B12 and B13 of data holding memory 7.

After the process in steps S22 to S24 (recovery) is complete, state determination flag FLG is initialized (=0) in step S25. Then, after a normal sate is attained in step S25, the process in steps S12 to S21 described above is performed.

Note that data to be written in data protection memory 8 has only to correspond the content stored in data holding memory 7 on a one-to-one basis, and may be for example the inverse of data in data holding memory 7.

Data holding memory 7 and data protection memory 8 need only be non-volatile (such as flash memory).

Furthermore, state determination flag FLG may be formed by a non-volatile memory.

As described above, even if an abnormality occurs in data writing caused by a power supply abnormality, IC card 200 can normally perform the next data communication processing, irrespectively of the normality/abnormality of the previous data reception, because the card permits normal data to be recovered.

As in the foregoing, there are provided an abnormality determination circuit, a data holding memory, and a memory for saving data according to the present invention, and therefore, the content of the data holding memory can be quickly recovered using the data which has been saved in the memory for saving data even if a data abnormality occurs because of some trouble during data commination, so that the next data communication processing can be normally performed irrespectively of the normality/abnormality of the previous reception.

Also, as a result, the reliability of the IC card in communication may be significantly improved.

## Claims

1. An IC card which performs a data communication in response to externally applied data, comprising:
first storage means (2, 7) to which said externally applied data is written;
determination means (1) for determining a state in which said externally applied data is written to said first storage means (2, 7);
second storage means (3, 8) into which data in said first storage means (2, 7) is saved; and
wherein
if said determination means (1) determines that the written state of said data is normal, before new externally applied data is written into a prescribed region of said first storage means (2, 7), data already present in said prescribed region is saved in said second storage means (3, 8), while if said determination means (1) determines that the written state of said data is abnormal, data in a prescribed region of said first storage means (2, 7) is recovered at least once, using the data saved in said storage means (3, 8) before accessing to said first storage means (2, 7) is started after said IC card is newly activated.

2. The IC card according to claim 1, wherein
said second storage means (3) has a capacity equal to or larger than a capacity to store said externally applied data received by one said data communication.

3. The IC card according to claim 1, wherein
said second storage means (8) has a capacity equal to or larger than a capacity to store data produced by dividing said externally received by one said data communication.

4. The IC card according to claim 1, wherein
said first storage means (2, 7) and said second storage means (3, 8) are non-volatile memories.

5. The IC card according to claim 1, wherein
said first storage means (2, 7) and said second storage means (3, 8) are provided in the same chip and separated by addresses.

6. The IC card according to claim 1, wherein
said determination means (1) detects a change in a power supply potential supplied for said data communication and determines the written state of said data in response to the change in said detected power supply potential.
